# EUROPEAN PATENT APPLICATION

(11) **EP 2 669 941 A1**
(43) Date of publication of application: **04.12.2013**
(21) Application number: 12740014.1
(22) Date of filing: 24.01.2012
(51) Int. Cl.: H01L 23/15

(54) **CIRCUIT SUBSTRATE AND SEMICONDUCTOR DEVICE USING SAME**

(30) Priority: 28.01.2011 JP 2011015899
(71) Applicant: Hitachi, Ltd., Tokyo 100-8280 (JP)
(72) Inventor: MORITA Toshiaki, Hitachi-shi Ibaraki 319-1292 (JP); IDE Eiichi, Hitachi-shi Ibaraki 319-1292 (JP); YASUDA Yusuke, Hitachi-shi Ibaraki 319-1292 (JP); ANDO Takashi, Hitachi-shi Ibaraki 319-1292 (JP)
(74) Representative: Beetz & Partner
(86) International application number: PCT/JP2012/051435
(87) International publication number: WO 2012/102267

(57) **Abstract**

The present invention aims at providing a circuit board 125 in which a thermal stress or a thermal strain in a phase of manufacture is reduced, and which has a low thermal resistance and is low in cost, and a semiconductor device using the same. The circuit board 125 includes a ceramics substrate 110 containing therein a nitride, a circuit wiring board 130 joined to one surface of the ceramics substrate 110 through a joining layer 120, and a metallic supporting member 125' joined to the other surface of the ceramics substrate 110 through a joining layer 120. The joining layer 120 is a sintered body containing therein silver or copper, and an oxide layer is formed in a joining interface between the ceramics substrate 110 and the sintered body. The oxide layer is composed of a polycrystalline layer on a side of the ceramics substrate 110, and is composed of an amorphous layer on a side of the sintered body.

## Description

### Technical Field

The present invention relates to a ceramics circuit board applied to a power semiconductor module, and a semiconductor device using the same.

### Background Art

A semiconductor device in which a semiconductor element base substance is mounted on a metallic supporting member has a high degree of freedom for circuit application because all of electrodes are electrically insulated from all of package members including the metallic supporting member to be drawn out to the outside. For example, even in a use example in which a pair of main electrodes is isolated from a grounding electric potential on a circuit, a package can be fixed to a grounding electric potential portion irrespective of an electrode electric potential. Thus, the mounting of the semiconductor device becomes easy.

To safely and stably operate the semiconductor element, it is necessary to efficiently diffuse the heat generated in a phase of the operation of the semiconductor device, to the outside of the package. This heat diffusion is normally attained by transferring the heat from the semiconductor element base substance as a heat generation source to the atmosphere through members adhered to the semiconductor element base substance. The semiconductor device includes in this heat transfer path an insulator, an adhesive material layer used in a portion or the like to which the semiconductor base substance is adhered, and a metallic supporting member.

In addition, the perfect insulating property is required as an electric power which the circuit including the semiconductor device treats becomes higher and the required reliability (such as temporal stability, a humidity resistance, and a heat resistance) becomes higher. In addition to the heat resistance in the case where an ambient temperature of the semiconductor device rises due to an external cause, the heat resistance here includes the heat resistance in the case where the electric power which the semiconductor device treats is large and thus the heat generated in the semiconductor base substance becomes large.

On the other hand, since certain organized electric circuits including the semiconductor element base substance are generally incorporated in the semiconductor device, at least a part of the circuits and the supporting member need to be electrically insulated from each other. For example, as a first prior art, a power module device is known in which an assembly in which a Si chip is mounted to an AlN ceramics substrate having both of the faces to which copper boards are joined (hereinafter referred to as a copper clad AlN board) is integrated with a copper supporting member by soldering.

In this first prior art, in the copper clad AlN board, features such as high heat conductivity (190 W/m·K), a low coefficient of thermal expansion (4.3 ppm/°C), and a high insulating property (1015 Ω·cm) which AlN has, and features such as high heat conductivity (403 W//m·K), and high electric conductivity (1.7 × 10⁻⁶ Ω·cm) which copper has are combined with each other. Thus, the copper clad AlN board is a component (or a part) which is effective in obtaining a module device in which a semiconductor base substance for power (Si: 3.5 ppm/°C) having a high current density and remarkable heat generation is directly mounted by the soldering, and thus which has the excellent heat dissipation property and reliability.

In general, the copper clad board plays a role in electrically insulating the semiconductor element base substance mounted to the copper clad AlN board by the soldering, or the electric circuit formed on the copper clad AlN board from the copper supporting member. In addition, the board also plays a role in forming a heat flow channel extending from the semiconductor base substance to a cooling fin, thereby enhancing a heat dissipation effect of the heat flow channel. Further, according to the copper clad AlN board, since the semiconductor base substance having a small coefficient of thermal expansion can be directly mounted without using a special thermal expansion relaxing material (for example, Mo or W), it is possible to reduce the number of parts or components, and the number of incorporating processes in the power module device.

In addition, in a second prior art (Patent Document 1), a semiconductor module device is disclosed in which an assembly in which a thyristor chip is mounted to an aluminum substrate is mounted to a supporting member composed of a composite material obtained by dispersing SiC ceramic powders into Al or an Al alloy (hereinafter referred to as an Al/SiC composite material). In this prior art, since the alumina substrate (7.5 ppm/°C) is mounted to the Al/SiC composite material supporting member (6.7 to 14 ppm/°C) whose coefficient of thermal expansion is closely approximated to that of the alumina substrate, a connection portion between these members has the superior reliability and effectively acts on prevention of the heat dissipation deterioration.

In a third prior art (Patent Document 2), a ceramic circuit board with a heat sink is disclosed in which an insulating substrate obtained by adhering an Al board for a circuit wiring, and an Al board for heat diffusion to both surfaces of a ceramics substrate through Al-Si system brazing filler materials and the heat sink made of an Al/SiC composite material are joined to each other through an Al alloy. According to the third prior art, since the Al boards each having a small deformation resistance are joined to the both surfaces, crack destruction of the ceramics substrate is prevented. Also, since the heat sink is previously joined to the Al board for heat diffusion through the Al alloy within the heat sink, it is possible to reduce the member of manufacture of the power module.

In a fourth prior art (Patent Document 3), a circuit board is disclosed in which a ceramics substrate and a porous preform formed of SiC powder are made adjacent to each other, and the preform is impregnated with molten Al, thereby making an Al/SiC composite material, and at the same time, the Al/SiC composite material and the ceramics substrate are integrally joined to each other by molten Al, thereby forming an Al circuit portion on a surface of the ceramics substrate. As a result, it is possible to obtain the low-cost circuit board.

### Prior Art Documents

### Patent Documents

Patent Document 1: JP-7-26174-B
Patent Document 2: JP-10-65075-A
Patent Document 3: JP-2000-277953-A

### Summary of the Invention

### Problem to be Solved by the Invention

In general, in the semiconductor device, the copper clad AlN board to which the semiconductor base substance is mounted by the soldering is integrated with the copper supporting member by the same soldering as with the first prior art. Here, the reason why the copper board having the high heat conductivity is used as the supporting member is because the heat flow transmitted from the copper clad AlN board is spread to enhance the heat dissipation effect.

In this case, the reduction in reliability, such as the destruction of the solder layer and the cut-off of the heat flow channel, is easy to occur due to the large difference in coefficient of thermal expansion between the copper supporting member and the copper clad AlN board is large. Specifically, there are caused the following problems (1) to (3).

### (1) Thermal Stress, Strain

Since the coefficient of thermal expansion of the copper clad AlN board, and that of the copper supporting member are different from each other, either a residual thermal stress or a thermal strain is generated in these integral bodies. During the integration, the copper clad AlN board and the copper supporting member undergo a heat treatment process in which they are heated to above a melting point of the solder material and thereafter cooled to a room temperature. In this case, the members contract in accordance with the coefficients of thermal expansion peculiar to the members, with being fixed to one another at a solidifying point of the solder material, and the thermal stress or the thermal strain remains in the adhesive portion, and also the adhesive portion is deformed.

In general, since the semiconductor base substance for power is large in size, and plural semiconductor base substances and other elements are also mounted in the semiconductor device, areas of the insulating substrate and the brazing portion become large. For this reason, the residual thermal stress and the thermal strain are large, and thus the deformation of the members is easy to promote. When the thermal stress in a phase of the operation is repetitively applied to the semiconductor device, and is superimposed on either the residual thermal stress or thermal stain described above, there is generated the cut-off of the thermal flow channel due to a fatigue failure of the solder layer (especially, a #2 solder layer which will be described later). Such a matter impedes the normal operation of the semiconductor device.

### (2) Thermal Engagement and Break of Insulating Board Due to Warpage

Since the coefficient of thermal expansion of the copper clad AlN board, and the coefficient of thermal expansion of the copper supporting member are different from each other, a warpage is generated in these integral bodies. If the warpage is generated in the semiconductor device, then the loading of a heat conduction grease is not uniformly carried out when the semiconductor device is mounted to a cooling fin. As a result, the thermal engagement between the copper clad AlN board and the copper supporting member is not satisfactorily carried out, and thus the heat dissipation property in this channel is impaired, which makes the normal operation of the semiconductor device difficult.

### (3) Problem about Number of Assemblies and Difficulty of Lead-Free Soldering

A process for soldering the semiconductor device and the copper clad AlN board to each other (formation of the #1 solder layer), and a process for integrating the copper clad AlN board and the copper supporting member with each other by the same soldering (formation of the #2 solder layer) are required and thus the number of assemblies of the semiconductor device is increased. In addition, although in general, a temperature hierarchy (the solder members having different melting points) is required in a process for forming the #1 solder layer and the #2 solder layer, with a combination of existing lead-free solder materials, it is difficult to obtain the sufficient temperature hierarchy.

The supporting member in the second prior art is the composite material. Thus, in the supporting member, the porous preform composed of the SiC ceramics powder is impregnated with the molten metal containing therein Al as a principal component, thereby dispersing the SiC powder into an Al matrix metal (hereinafter referred to as Al/SiC). Since the coefficient of thermal expansion of this member is controlled by an amount of addition of the SiC powder, it is possible to clear the problems (1) and (2) described above. However, the assembly of the semiconductor device needs to go through both of the processes for formation of the #1 and #2 solder layers, and thus the problem (3) described above still remains. In addition, since the alumina insulating member and the Al/SiC supporting member are made in the difficult processes, a problem about the cost still remains.

Since in the semiconductor device obtained by using the circuit board with the heat sink based on the third prior art, the insulating substrate and the supporting member are previously integrated with each other, the subsequent processes for assembly of the semiconductor device are simplified. However, this circuit board with the heat sink is obtained by going through the process in which the Al clad AlN board and the Al/SiC heat sink which were made in the different processes are laminated on top of each other, and are heated in the vacuum while they are pressured. A great cost is required for this process, which becomes finally an obstacle to the cheap price promotion for the semiconductor device. In addition thereto, an oxide which was formed on the surfaces of the Al clad AlN board and the Al/SiC heat sink which are previously made, remains on an interface after the joining, which is easy to impair the connection property and the reliability of this interface.

Since in the ceramics circuit board based on the fourth prior art, the Al/SiC base board and the ceramics insulating board are previously, directly integrated with each other, the subsequent processes for assembly of the power module are simplified. In addition thereto, an Al alloy molten metal is injected into a predetermined mold, whereby the production of the Al/SiC, and the wiring to the ceramics insulating board are carried out in the same process as that for the integration. For this reason, the fourth prior art has the possibility that the ceramics circuit board can be made at the relatively low cost, and finally, it is expected that the fourth prior art can contribute to the cheap price promotion for the semiconductor device. However, in the case of this structure, since the Al/SiC base board and the ceramics insulating board are directly integrated with each other at the relatively high temperature exceeding 600°C, the stress, the strain, and the warpage deformation are easy to generate in the integrated bodies, and thus the problem (2) described above still remains.

It is therefore an object of the present invention to provide a circuit board which has a low thermal resistance and is low in cost by reducing either a thermal stress or a thermal strain in a phase of manufacture, and a semiconductor device using the same.

A circuit board of the present invention includes a ceramics substrate containing therein a nitride, a circuit wiring board joined to one surface of the ceramics substrate through a joining layer, and a metallic supporting member joined to the other surface of the ceramics substrate through a joining layer. The joining layer is a sintered body containing therein silver or copper, and an oxide layer is formed in a joining interface between the ceramics substrate and the sintered body. The oxide layer is composed of a polycrystalline layer on a side of the ceramics substrate, and is composed of an amorphous layer on a side of the sintered body.

In addition, preferably, the oxide layer has a thickness of 1 nm to 10 µm, and the amorphous layer has a thickness of 0.1 nm to 100 nm.

In addition, preferably, a silicon nitride or an aluminum nitride is used as the ceramics substrate. In this case, the oxide layer is an oxide of either silicon or aluminum.

In addition, preferably, thermal conductivity of the sintered body is 50 W/mK to 430 W/mK.

Also, a semiconductor device of the present invention is obtained by mounting a semiconductor element on a circuit wiring board of the circuit board described above.

### Effects of the Invention

As set forth hereinabove, the present invention can provide the circuit board which is excellent in the heat dissipation and is low in cost by reducing either the thermal stress or the thermal strain which is generated in the phase of the manufacture, and the semiconductor device. In addition, the realization of the reduction in the number of joining portions results in that the securement of the long-term reliability becomes easy, and the simplification of the manufacturing processes can also be realized. From those, it is possible to realize the large cost-cutting.

### Brief Description of the Drawings

FIG. 1 is a diagram explaining a structure of a circuit board of the present invention.
FIG. 2(a) is a top plan view of an insulation type semiconductor device of the present invention, and FIG. 2(b) is a cross sectional view taken on line A-A of FIG. 2 (a).
FIG. 3 is a cross sectional schematic view of a semiconductor device circuit board of the present invention.
FIG. 4 is a diagram showing a joining property of a joining portion according to the present invention.
FIG. 5 is a diagram showing a joining property of the joining portion according to the present invention.
FIG. 6 is a diagram showing a state of the joining portion according to the present invention.
FIG. 7 is a diagram showing a state of the joining portion according to the present invention.
FIG. 8 is a diagram showing a joining property of the joining portion according to the present invention.
FIG. 9 is a diagram showing a joining property of the joining portion according to the present invention.
FIG. 10 is a bird's eye schematic view explaining a main portion of a semiconductor device of the present invention.

### Modes for Carrying Out the Invention

Hereinafter, modes for carrying out the present invention will be described.

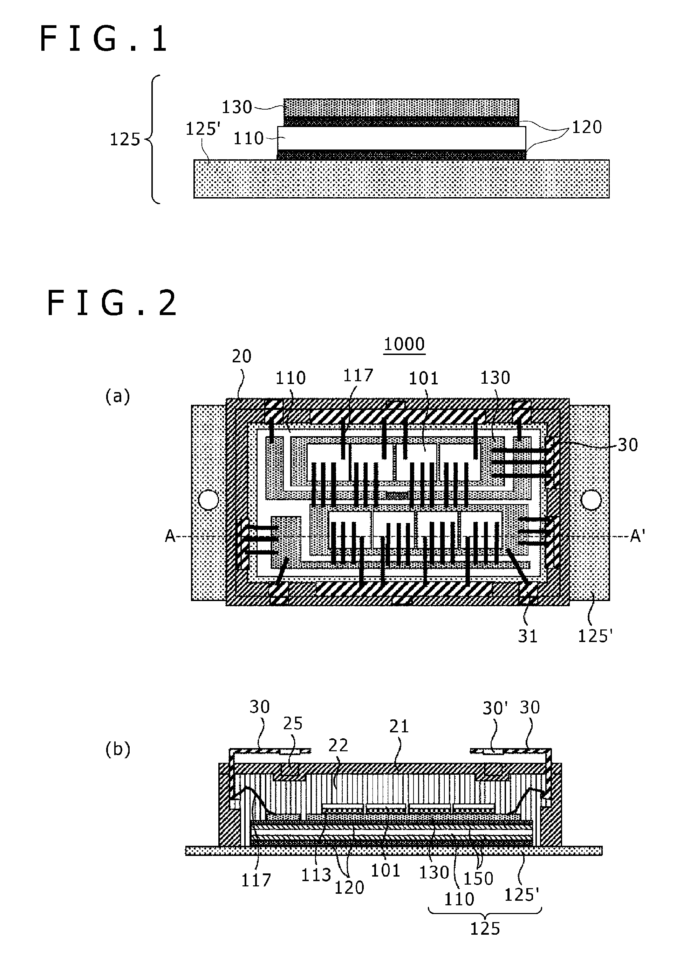

FIG. 1 is a diagram explaining a structure of a circuit board according to the present invention. A circuit board 125 includes a ceramics substrate 110 containing therein a nitride, a circuit wiring board 130 which is joined to one surface of the ceramics substrate 110 through a joining layer 120, and a supporting member 125' which is joined to the other surface of the ceramics substrate 110 through the joining layer 120. As will be described later, an oxide layer is formed in a joining interface between the ceramics substrate 110 and the joining layer 120, and the oxide layer is a polycrystalline layer on a ceramics substrate side thereof and is an amorphous layer on a sintered body side thereof.

Either a metal which is excellent in heat resistance property or a composite material containing therein the metal and thermal conductivity is suitable for the supporting member 125'. Specifically, either copper or an alloy containing therein copper, or either aluminum or an alloy containing therein aluminum is better.

A convex-concave-like fin may be provided in a surface facing the supporting member 125' and a surface which the joining layer 120 contacts, thereby enhancing a heat dissipation property.

Ceramics which is excellent in heat resistance property and pressure resistance property, and which has a high strength is suitable for the ceramics substrate 110. While either an oxide or nitride containing therein aluminum or silicon is given as a ceramics material, in particular, the nitride which has a high strength and an excellent thermal conductivity is preferable. Specifically, an aluminum nitride and a silicon nitride are given. In particular, the silicon nitride is known as high-strength ceramics. In addition, a thickness of the insulating substrate is determined depending on a dielectric strength voltage and a strength which are required for the circuit board 110. Plural sheets of ceramics boards may be mounted as may be necessary, and in this case, a silicon nitride board and an aluminum nitride board may be combined with each other as may be necessary.

Either a metal or a composite material containing therein a metal which is excellent in heat resistance property, thermal conductivity, and conductivity is suitable for the circuit wiring board 130. Specifically, either copper or an alloy containing therein copper, or either aluminum or an alloy containing therein aluminum is better.

Either a sintered body containing therein silver or copper is used for the joining layer 120. For the joining layer 120, it is desirable that an interface between the supporting member 125' and the ceramics substrate 110, and an interface between the ceramics substrate 110 and the circuit wiring board 130 can be individually joined at a low temperature. The reason for this is because joining these interfaces individually at the low temperature can reduce the thermal stress and warpage remaining in the joining portion.

As a joining technique for carrying out the joining at the low temperature by the metallic sintered body, there is known a joining material utilizing a low-temperature firing function of metallic nanoparticle. However, in the case where a conventional joining material is used in which metallic particles having an average particle size of 100 nm or less is used as a base compound for the joining, the metal and the ceramics cannot be joined to each other. On the other hand, there is a joining technique using a joining material composed of metallic oxide particles, and a reducing agent made of an organic material for reducing the metallic oxide particles. This joining technique utilizes a phenomenon that the metallic oxide particles are reduced in phases of heating and pressing during the joining, whereby metallic particles having an average particle size of 100 nm or less are created, and the sintering of the metallic particles having an average particle size of 100 nm or less is caused to turn into a bulk metal. According to this joining technique, the joining is possible for aluminum as oxide system ceramics. However, it is impossible to obtain the sufficient joining strength for nitride system ceramics. The reason for this is because although in the joining of the non-oxide system ceramics to an insulating substrate, the metallic elements need to be diffused into the inside of the ceramics by the reductive reaction heat of the metallic oxide particles to enhance the joining strength, it is not easy to diffuse the metallic elements into the nitride. Then, the inventors honestly studied and as a result, found out that an oxide layer into which metallic elements are easy to diffuse is formed on a surface of nitride system ceramics to promote the diffusion of the metallic particles, thereby making it possible to carry out the joining to the nitride system ceramics. That is to say, the oxide layer is formed on the surface of the nitride system ceramics, and the joining is carried out in the atmospheric ambient by using the joining material composed of the metallic oxide particles, having the average particle size of 1 nm to 100 µm, as a metallic particle precursor, and the reducing agent made of the organic material for reducing the metallic oxide particles, whereby it is possible to obtain the excellent joining strength for the nitride ceramics. The oxide layer is present in the joining interface between the ceramics substrate and the sintered body described above after the joining. Also, the oxide layer is composed of the polycrystalline layer on the ceramics substrate side thereof, and is composed of the amorphous layer on the sintered body side thereof. The oxide layer has a thickness ranging from 1 nm to 10 µm, and the amorphous layer has a thickness ranging from 0.1 nm to 100 nm, thereby making it possible to obtain the excellent joining strength.

As a method of forming the oxide layer on the ceramics substrate, for example, the ceramics substrate is fired in the atmosphere at the temperature of 1000°C, whereby the oxide layer having a thickness of several nanometers can be formed on the surface of the ceramics surface. In addition, the firing may also be carried out in a highly-concentrated oxygen ambient. In addition, an oxide layer can also be formed on an insulating substrate surface by utilizing a film deposition technique based on an evaporation method, a thermal spraying method or an aerosol deposition method.

This joining utilizes a phenomenon that the reducing agent made of the organic material is added to the metallic particle precursor, whereby the metallic particle precursor is reduced in the lower temperature than that in the case where the metallic particle precursor single body is thermally decomposed, and in this case, the metallic particles having the particle size of 100 nm or less are made, and the metallic particles are mutually fused, thereby carrying out the joining. With regard to silver oxide particles, since under the presence of the reducing agent, the metallic particles having a particle size of 100 nm start to be made at 200°C or less, it is possible to attain the joining between the ceramics and the metal even at the low temperature of 500°C or less which has been conventionally difficult. In addition, since the metallic particles having the particle size of 100 nm or less are made in place during the joining, it is unnecessary to make the metallic particles whose surfaces are protected by the organic material, and thus it is possible to attain the manufacture of the material for the joining, the simplification of the joining process, and the large cost-cutting of the joining material. In addition, the surface of the oxide layer formed on the surface of the nitride ceramics becomes an active state by the reduction heat generating operation of the reducing agent, and the oxide layer whose surface is activated, and silver can attain the strong coupling.

A description will now be given with respect to the joining material with which the ceramics substrate containing therein the nitride and the circuit wiring board, and the supporting member are joined to one another. As described above, the joining material used in the present invention is the joining material composed of the metallic oxide particles, having the average particle size of 1 nm to 100 µm, as the metallic particle precursor, and the reducing agent made of the organic material for reducing the metallic oxide particles.

The reason why the metallic particle precursor having the average particle size of 1 nm or more and 100 µm or less and used to make the metallic particles having the particle size of 100 nm or less is regulated as the metallic oxide is because the contraction in volume in the phase of the joining is small because a contained amount of metal in the metallic particle precursor is high, and thus oxygen is generated in the phase of decomposition, which results in the oxidation decomposition of the organic material being promoted. In addition to a silver oxide (Ag₂O, AgO), a copper oxide (CuO) is also given as the metallic oxide particle used in the joining material described above, and at least one or more kinds of metals can be used from these groups. Since the metallic oxide particle made of the silver oxide (Ag₂O, AgO) or the copper oxide (CuO) generates only oxygen in the phase of the reduction, the residue after the joining is hard to remain, and a rate of reduction in volume is also small. In addition, the particles having the average particle size of 1 nm or more and 100 µm or less, preferably, 50 µm or less are desirably used as the metallic oxide particles. The reason why the average particle size is set to 100 µm or less is because the metallic particles having the average size of 100 nm or less is hard to create during the joining by the reduction of the metallic oxide particles and as a result, the gaps among the particles become much, which results in that it is difficult to obtain the dense joining type. In addition, the reason why the average particle size is set to 1 nm or more is because it is difficult to make the metallic oxide particles having the average particle size of 1 nm or more. In addition, since in the joining material, the metallic particles having the particle size of 100 nm or less are created during the joining, thereby carrying out the joining, the particle size of the metallic oxide particles needs not to be set to 100 nm or less. Thus, the particles having the average particle size of 1 µm are preferably used from a viewpoint of the manufacture of the metallic oxide particles, the treatment, and the long-term pressing property. In addition, for the purpose of obtaining the denser joining layer, it is also possible to use the metallic particle precursor having the particle size of 1 nm to 100 nm.

Preferably, a contained amount of metallic particle precursor is set so as to exceed 50 parts by weight in the entire parts in the joining material and equal to or smaller than 99 parts by weight. The reason for this is because when the contained amount of metal in the joining material is more, the organic material residue becomes less after the joining at the low temperature, the attainment of the dense fired layer at the low temperature and the attainment of the metallic bonding in the joining interface become possible, and it is also possible to obtain the joining layer having the enhanced joining strength, the high heat dissipation property, and the high heat resistance property.

As the reducing agent concerned used in the joining material described above, it is only necessary to have the operation for reducing the metallic oxide particles. For example, it is possible to use one or more kinds of organic materials selected from an alcohol class, a carboxylic acid class, and an amine class. In addition, the reducing agent used is by no means limited to the organic material containing therein alcohol, carboxylic acid, and amine described above, and thus may use an organic material containing therein an aldehyde group, an ester group, a sulfonyl group, a ketone group, and the like.

As a compound containing therein an utilizable alcohol group, alkyl alcohol is given. For example, there are ethanol, propanol, butyl alcohol, pentyl alcohol, hexyl alcohol, heptyl alcohol, octyl alcohol, nonyl alcohol, decyl alcohol, undecyl alcohol, dodecyl alcohol, tridecyl alcohol, tetradecyl alcohol, pentadecyl alcohol, hexadecyl alcohol, heptadecyl alcohol, octadecyl alcohol, nonadecyl alcohol, and icosyl alcohol. In addition, it is possible to use a second class alcohol type, a third class alcohol type, alkanediol, and an alcohol compound having a cyclic type structure without being limited to a first class alcohol type. In addition thereto, many compounds each having an alcohol group such as ethylene glycol, and triethylene glycol may also be used. Also, compounds such as a citric acid, an asconbic acid, and glucose may be used.

In addition, as a compound containing therein a utilizable carboxylic acid, there is an alkyl carboxylic acid. As concrete examples concerned, there are given a butanoic acid, a pentanoic acid, a hexanoic acid, a heptanoic acid, an octanoic acid, a nonanoic acid, a decanoic acid, an undecanoic acid, a dodecanoic acid, a tridecanoic acid, a tetradecanoic acid, a pentadecanoic acid, a hexadecanoic acid, a heptadecanoic acid, an octadecanoic acid, a nonadecanoic acid, and an icosanoic acid. In addition, it is possible to use a second class carboxylic acid type, a third class carboxylic acid type, a dicarboxylic acid, and a carboxyl compound having a cyclic type structure without being limited to a first carboxylic acid type similarly to the case of the amino group described above.

In addition, alkylamine can be given as a compound containing therein a utilizable amino group. For example, there are butylamine, pentylamine, hexylamine, heptylamine, octylamine, nonylamine, decylamine, undecylamine, dodecylamine, tridecylamine, tetradecylamine, pentadecylamine, hexadecylamine, heptadecylamine, octadecylamine, nonadecylamine, and icodecylamine. In addition, a compound having an amino group may have a branch structure. As such examples concerned, there are 2-ethylhexylamine, 1,5 dimethylhexylamine and the like. In addition, it is also possible to use a second class amino type, and a third class amino type without being limited to a first class amine type. Moreover, such an organic material may have a cyclic structure.

In addition, metal carboxylate may be used as the reducing agent. The reducing agent having a melting point lower than the joining temperature agglutinates in the phase of the joining to cause the voids. However, since metal carboxylate is not molten by the heating in the phase of the joining, metal carboxylate can be used for reduction of the voids. In addition to metal carboxylate, a material may be used as the reducing agent as long as it is a metallic compound containing therein an organic material.

Here, the reducing agent such as ethylene glycol or triethylene glycol which is the liquid at 20 to 30°C is reduced to silver after a lapse of one day when the reducing agent is mixed with a silver oxide (Ag₂O) or the like and is left as it is. Therefore, after the mixing, the reducing agent needs to be immediately used. On the other hand, since mirystyl alcohol, laurylamine, an ascorbic acid or the like which is the solid in a temperature range of 20 to 30°C does not largely proceeds in reaction with the metallic oxide or the like even when mirystyl alcohol, laurylamine, an ascorbic acid or the like, and the metallic oxide or the like are left as they are for about one month, mirystyl alcohol, laurylamine, an ascorbic acid or the like is excellent in preserving property. Thus, when mirystyl alcohol, laurylamine, an ascorbic acid or the like, and the metallic oxide or the like are stored for a significant period of time after the mixing, they are preferably used. In addition, since the reducing agent used acts as a protective film for purified metallic particles having a particle size of 100 nm or less after the reducing agent has reduced the metallic oxide or the like, it is desirable that the reducing agent has a certain level of a carbon number. Specifically, desirably, the carbon number is equal to or larger than 2 and is equal to or smaller than 20. The reason for this is because when the carbon number is smaller than 2, the grain growth is caused concurrently with that the metallic particles are made, and thus it becomes difficult to make the metallic particles having the particle size of 100 nm or less. Also, the reason for this is because when the carbon number is larger than 20, the temperature of decomposition becomes high and the sintering of the metallic particles becomes hard to generate to cause the reduction in the joining strength.

All it takes is that an amount of use of the reducing agent is in the range of 1 part by weight to 50 parts by weight with respect to the entire weight of the metallic particle precursor. The reason for this is because when the amount of reducing agent is smaller than 1 part by weight, the amount of reducing agent is not enough to reduce the entire metallic particle precursor in the joining material, thereby making the metallic particles. In addition, the reason for this is because the amount of reducing agent exceeding 50 parts by weight is used, the residue after the joining becomes much and thus it is difficult to attain the metallic joining in the interface, and the densification in the joining silver layer. In addition thereto, when the reducing agent is made of only the organic material, preferably, a reduction rate of thermogravimetry in the phase of the heating up to 400°C is equal to or larger than 99%. The reason for this is because when the temperature of decomposition of the reducing agent is high, the residue after the joining becomes much and thus it is difficult to attain the metallic joining in the interface, and the densification in the joining silver layer. Here, the measurement of the reduction rate of thermogravimetry in the phase of the heating up to 400°C was carried out in the atmosphere at a rate of 10°C/min by using an apparatus, which is capable of measuring the thermogravimetry, such as TG/DTA6200 manufactured by Seiko Instruments, or TGA-50 manufactured by Shimadzu Corporation which is generally put on the market.

Although a combination of the metallic particle precursor and the reducing agent made of the organic material is especially by no means limited as long as the metallic particles can be made by mixing them with each other, preferably, a combination in which the metallic particles are not made at the room temperature is adopted from a viewpoint of the preserving property as the material for joining.

In addition, the joining material can also be mixed with the metallic particles which have the average particle size of 50 µm to 100 µm which is relatively large in the particle size in order to be used. The reason for this is because the metallic particles having the particle size of 100 nm or less and made during the joining plays a part to sinter the metallic particles having the average particle size of 50 µm to 100 µm. In addition, the metallic particles having the particle size of 100 nm or less may be previously mixed with one another. As a kind of metallic particle concerned, gold, silver, and copper are given. In addition to the above, it is possible to use an alloy made of at least one kind of metal or two or more kinds of metals selected from platinum, palladium, rhodium, osmium, ruthenium, iridium, iron, tin, zinc, cobalt, nickel, chromium, titanium, tantalum, tungsten, indium, silicon, aluminum, and the like.

Although the joining material used in this embodiment may be used by only the metallic particle precursor and the reducing agent made of the organic material, when the joining material is used as a paste-like form, a solvent may also be added thereto. When being immediately used after the mixing, there may be used the solvent, having a reduction action, for example, an alcohol class such as methanol, ethanol, propanol, ethylene glycol, triethylene glycol or terpineol. However, when being stored for a significant period of time, preferably, there is used the solvent, having the weak reduction action at the room temperature, such as water, hexane, tetrahydrofuran, toluene or cyclohexane. In addition, when the solvent such as myristyl alcohol in which the reduction is hard to cause at the room temperature is used, the solvent can be stored for a significant period of time. However, when the solvent, such as ethylene glycol, which has the weak reduction action is used, preferably, the joining material is mixed with the solvent in order to be used in the phase of use.

In addition, for the purpose of enhancing dispersibility of the metallic particle precursor to the solvent, the surround of the metallic particle precursor may be coated with an organic material by using a dispersing agent as may be necessary, thereby enhancing the dispersibility. As the disposing agent used in the present invention, it is possible to use polymer dispersing agents such as DISPERBYK160, DISPERBYK161, DISPERBYK162, DISPERBYK163, DISPERBYK166, DISPERBYK170, DISPERBYK180, DISPERBYK182, DISPERBYK184, and DISPERBYK190 (all made by BYK-Chemie Additives & Instruments), MEGAFACF-479 (made by Dainippon Ink And Chemicals, Inc.), Solsperse20000, Solsperse24000, Solsperse26000, Solsperse27000, and Solsperse28000 (all made by Avecia Ltd.) as the commercially available disposing agent in addition to polyvinyl alcohol, polyacrylonitrile, polyvinylpyrrolidone, lyethylene glycol, and the like. A use amount of dispersing agent is set to the range in which the use amount of dispersing agent is equal to or larger than 0.01 wt% and does not exceed 45 wt% in the material for joining in the metallic particle precursor.

For these paste materials, there are a method in which a paste is squirted from a minute nozzle by an inkjet method to be applied to an electrode on a substrate or on a connection portion of electronic parts or components, and a method of carrying out application to only a necessary portion(s) by using a metal mask in which an application portion is opened or a mesh-like mask. In addition, there are a method of carrying out application to a necessary portion(s) by using a dispenser, and a method in which a water-shedding resin containing therein silicon, fluorine, or the like is applied by using a metal mask in which only a necessary portion(s) is(are) opened or a mesh-like mask or a water-shedding resin having photosensitivity is applied onto a substrate or on an electronic part or component, and exposure and development are carried out, thereby removing a portion to which a paste composed of the fine particles described above is to be applied, and thereafter, a paste for joining is applied to the opening portion. Further, there is a method in which after a water-shedding resin is applied onto a substrate or onto an electronic part or component, a paste application portion composed of the metallic particles described above is removed away by using a laser beam, and thereafter, a paste for joining is applied to the opening portion. These application methods can be combined with one another in accordance with an area and a shape of an electrode to be joined. In addition, when the organic material, such as myristyl alcohol or an ascorbic acid, which is the solid in the room temperature is used as the reducing agent, there is a method in which the reducing agent is mixed with the metallic particle precursor and is formed into a sheet-like shape by applying thereto a pressure, thereby being used as the joining material.

In the joining using this joining material, it is essential that the metallic particles having the particle size of 100 nm or less are made from the metallic particle precursor in the phase of the joining, and the heat and the pressure are applied while the organic material in the joining layer is exhausted in order to carry out the metallic bonding by the fusion of the metallic particles having the particle size of 100 nm or less. As the joining condition concerned, it is preferable to apply the heat equal to or higher than 50°C and equal to or lower than 400°C within a time equal to or longer than 1 second and equal to shorter than 10 minutes, and the application of the pressure of 0.01 to 10 MPa.

In the joining of the present invention, the metallic oxide particles turn into the pure metallic ultrafine particles which are not the oxide and which have the particle size of about 0.1 to about 50 nm by the heating in the phase of the joining, and the resulting pure metallic ultrafine particles are mutually fused to become the bulk. The melting temperature after the pure metallic ultrafine particles have become the bulk is identical to the melting temperature of the metal in the normal bulk state, and thus the pure metallic ultrafine particles have the features that the pure metallic ultrafine particles are molten by the heating at the low temperature and are not re-molten until the pure metallic ultrafine particles are heated at the melting temperature in the bulk state after the melting. This provides a merit that since the joining can be carried out at the low temperature when the pure metallic ultrafine particles are used, and the melting temperature rises after the joining, thereafter, when other electronic parts or components are joined to each other, a joining portion is not re-molten. In addition, the thermal conductivity of the joining layer after the joining can be set to the range of 50 to 430 W/mK, which is excellent in heat dissipation as well. In addition thereto, there is a merit that since the precursor is the metallic oxide, the low cost can be achieved. It is used that for the purpose of promoting the reduction effect, it is necessary to cover the metallic oxide particles with the organic material such as alcohol. All it takes is that the atmosphere in the phase of the joining is the atmospheric ambient.

The amorphous layer is formed in the interface obtained by the joining to the joining material and through the joining method described above. In order to enhance the joining strength, it is required that the metallic particles created by the reduction are bonded to corresponding (party) members in terms of a metal by the joining. It is noted that even when the silver oxide and the copper oxide are present in a mixing style, the joining can be carried out similarly to the above case, and this case has an advantage that the corrosion resistance is enhanced.

A semiconductor element is joined to the circuit wiring board 130 of the circuit board shown in FIG. 1, thereby making it possible to obtain a semiconductor device.

The joining material and joining method described above are used in the joining between the ceramics substrate and the circuit wiring board, and between the ceramics substrate and the supporting member, whereby it is possible to obtain the circuit board in which either the thermal stress or the thermal strain in the phase of the manufacture is reduced, and which has the low thermal resistance and is low in cost, and the semiconductor device using the same.

Although hereinafter, examples of the present invention will be described with reference to the drawings, the present invention is by no means limited to the following examples.

### [Examples]

### (Example 1)

FIG. 2 is a top plan and cross sectional schematic views explaining a basic structure of a semiconductor device 1000 of the present invention. (a) shows a top plan view, and (b) shows a cross sectional view taken on line A-A' of (a). A silicon nitride having a surface on which an oxide layer 150 is formed is used as the ceramics substrate 110. The circuit board 130 made of copper is joined to one surface of the ceramics substrate 110 by the silver system joining layer 120, and the supporting member 125' made of copper is joined to the other surface thereof by the silver system joining layer 120, thereby structuring the circuit board 125. A semiconductor base substance 101 is mounted on a circuit wiring board 130. The semiconductor base substance 101 is a MOSFET element. A resin case 20 made of polyphenyl sulfide and provided with a main terminal 30 and a subsidiary terminal 31 is mounted to the supporting member 125'. Wire bonding using an Al thin wire 117 is carried out between the element base substance 101 and the circuit wiring board 130, between the semiconductor base substance 101 and the subsidiary terminal 31, and between the circuit wiring board 130 and the main terminal 30. A silicon gel resin 22 is filled in the inside of the resin case 20, and a resin cover 21 made of polyphenyl sulfide is provided on an upper portion of the resin case 20. Here, eight element base substances 101 are fixedly mounted onto the circuit wiring board 130 provided above the ceramics substrate 110 by a silver system joining layer 113. In addition, a thermistor for temperature detection (not shown) is joined to the circuit wiring board 130 by a solder (not shown), and the circuit wiring board 130 is communicated with the subsidiary terminal 31 by the Al thin wire 117. It is noted that although omitted in the drawing the resin case 20 and the supporting member 125', and the resin case 20 and the resin cover 21 are each fixed to each other by using a silicon adhesive resin (not shown). A depression 25 and a hole 30' are provided in a thick portion of the resin cover 21, and the main terminal 30, respectively, and a screw (not shown) through which the semiconductor device 1000 is communicated with an external circuit wiring is accommodated therein. The main terminal 30 or the subsidiary terminal 31 is formed in such a way that a copper board which is previously punch-formed into a predetermined shape is subjected to Ni plating, and thus is mounted to the resin case 20 by an injection forming method.

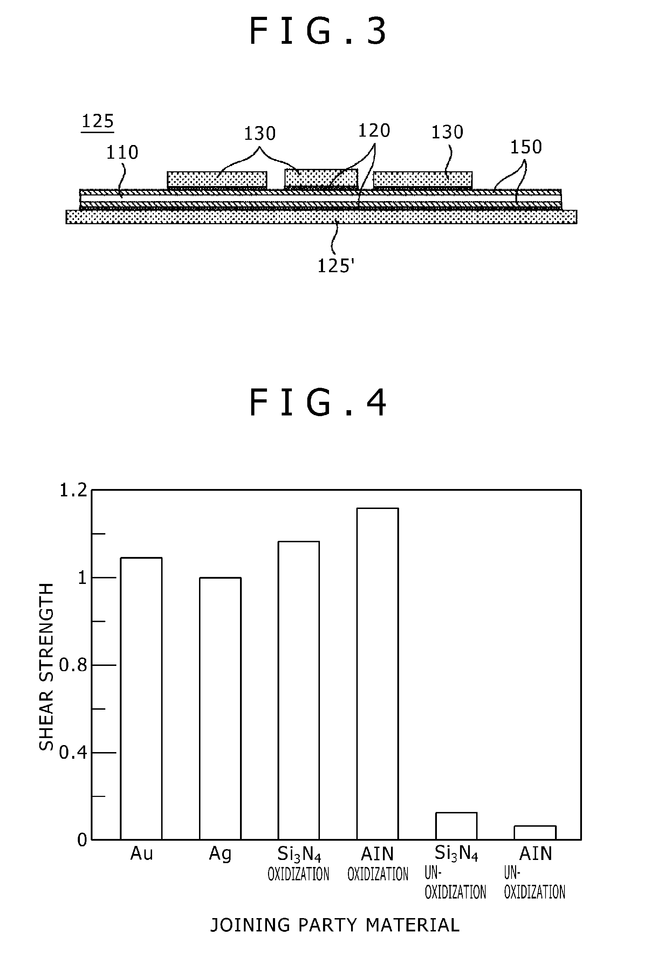

FIG. 3 is a cross sectional schematic view of the circuit board for the semiconductor device of the present invention. The circuit board 125 has a structure in which the circuit wiring board 130 is joined to one principal surface of a silicon nitride board (a coefficient of thermal expansion: 3.4 ppm/°C, thermal conductivity: 90 W/m·K, a thickness: 0.3 mm, a size: 30 × 50 mm) as the ceramics substrate 110 by the silver system joining layer 120, and the supporting member 125' made of either copper or a copper alloy is joined to the other surface of the ceramics substrate 110 by the silver system joining layer 120. Here, the joining layer 120 has a thickness adjusted to 50 µm, and the circuit wiring board 130 has a thickness adjusted to 0.4 mm. An oxide film 150 having a thickness of 5 µm is formed on the surface of the ceramics substrate 110.

The circuit wiring board 130 and the supporting member 125' in the insulating board 125 require (a) A point in which the thermal conductivity is high, (b) a point in which the joining property with the ceramics substrate 110 is excellent, and the like. The point (a) has meaning which is important in that the heat flow discharged from the semiconductor base substrate is efficiently discharged to the outside when the heat flow goes through a matrix area.

In the wiring and heat radiating board described above, a Ni plating layer (thickness: 6 µm, not shown) is formed on each of the surface metallic layers of the circuit wiring board 130 and the supporting member 125' in a nonelectrolytic wet plating process. The reason why the Ni plating layer is provided on the circuit wiring board 130 is in that the wire-bonding property of the circuit wiring board 130 is enhanced. In addition, the Ni plating layer is provided from the sense of preventing an internal change of properties by the cutting-off from the outside air atmosphere.

In manufacturing processes for the circuit board 125, firstly, after the silver oxide system paste described above has been printed on the ceramics board, a metallic board (copper board) for wiring, and a metallic board for backing are laminated on both surfaces of the ceramics board, and the resulting lamination body is subjected to the application of the pressure, and the heating, thereby joining the metallic boards and the ceramics board to each other. The ceramics is the nitride system, and the surface of the ceramics is oxidized. As the oxidizing method concerned, the oxidation is carried out at 1000°C for 60 minutes in the atmosphere. 90 wt% silver oxide particles containing therein 5 wt% myristyl alcohol, and 10 wt% glycol system solvent are mixed with each other, and the resulting material is used as the silver oxide system paste. The silver oxide system paste is disposed between the members to be joined to each other, and in this state, the heat at 400°C is applied for about 60 minutes, and at the same time, the pressure of 1.0 MPa is applied in the atmosphere, thereby making it possible to carry out the joining. The sintered body after the joining has undergone the pure argentation. In addition, an ultrasonic wave can also be applied during the joining.

The circuit board 125 is reflected in the simplification of the subsequent manufacturing processes for the semiconductor device. In the circuit board 125, the supporting member 125' serving as the heat radiating board as well and the ceramics substrate 110 serving as the insulating board as well are previously integrated with each other by the joining layer 120, and also the circuit wiring board 130 is formed on the semiconductor base substance mounting surface of the ceramics substrate 110. Therefore, in the stage of manufacturing the semiconductor device 1000, the semiconductor base substance 101 as the second main member only has to be mounted. This results in that in the stage of assembling the semiconductor device 1000, the number of processes and the number of parts or components can be reduced as compared with the case of the conventional method. This, of course, contributes to the cost reduction of the semiconductor device 1000. In addition, this can largely contribute to the reduction of the thermal resistance of the semiconductor device along with the simplification of the vertical structure. It is noted that for completing the semiconductor device, it is necessary to go through the processes such as the wire bonding, the resin case mounting, and the resin mold. These processes are common to the case as well of the conventional processes.

FIG. 4 shows results of joining strength evaluation which was carried out for the joining portion of the present invention, and shows results in which the joining temperature was set constant at 400°C, the application of pressure was set constant at 1.0 MPa, and an influence with the joining party material was investigated. The silver oxide system paste used in this evaluation had the composition in which 90 wt% silver oxide particles (contains therein 5 wt% myristyl alcohol, and underwent the pure argentation after the joining), and 10 wt% glycol system solvent (underwent the pure argentation after the joining) were mixed with each other, and the joining to Au, Ag, and Si₃N₄ (presence and absence of the surface oxidation), AlN (presence and absence of the surface oxidation) was carried out in the atmosphere. An axis of ordinate of FIG. 4 represents a strength in shear which is normalized by a value of a strength in shear for the Ag electrode.

As a result, with regard to the joining strength for the high thermally-conductive nitride ceramics (Si₃N₄, AlN) whose surface was oxidized, the joining strength equal to or higher than that in the case of the joining to Au, Ag is obtained, and the strong joining is attained. On the other hand, it was found out that the joining strength for the nitride ceramics (Si₃N₄, AlN) whose surface was not oxidized is largely lower than that in the oxidization case, and thus the strong joining is not obtained.

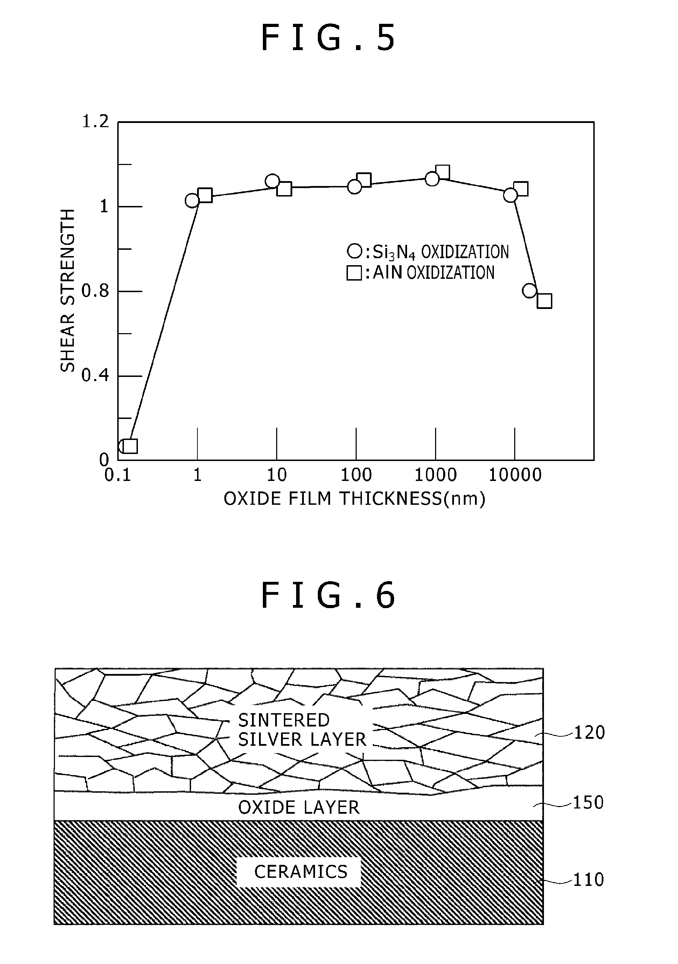

FIG. 5 shows the joining strength for the high thermally-conductive nitride ceramics (Si₃N₄, AlN) whose surface was oxidized, and shows the strength in shear for the thickness of the surface oxide layer thereof. Similarly to the case of FIG. 4, an axis of ordinate represents the strength in shear which is normalized by the value of the strength in shear for the Ag electrode. As a result, it was found out that when the thickness of the oxide film is equal to or larger than 1 nm, the high strength is obtained, and when the thickness of the oxide film exceeds 10 µm, the strength is reduced. The reason why the strength is reduced when the oxide thickness becomes thick is because a shear failure is generated within the oxide film layer. On the other hand, when a surface is oxidized even a little, the high strength can be ensured. This offers an advantage that the high joining strength promotion is obtained without impairing the thermal conductivity.

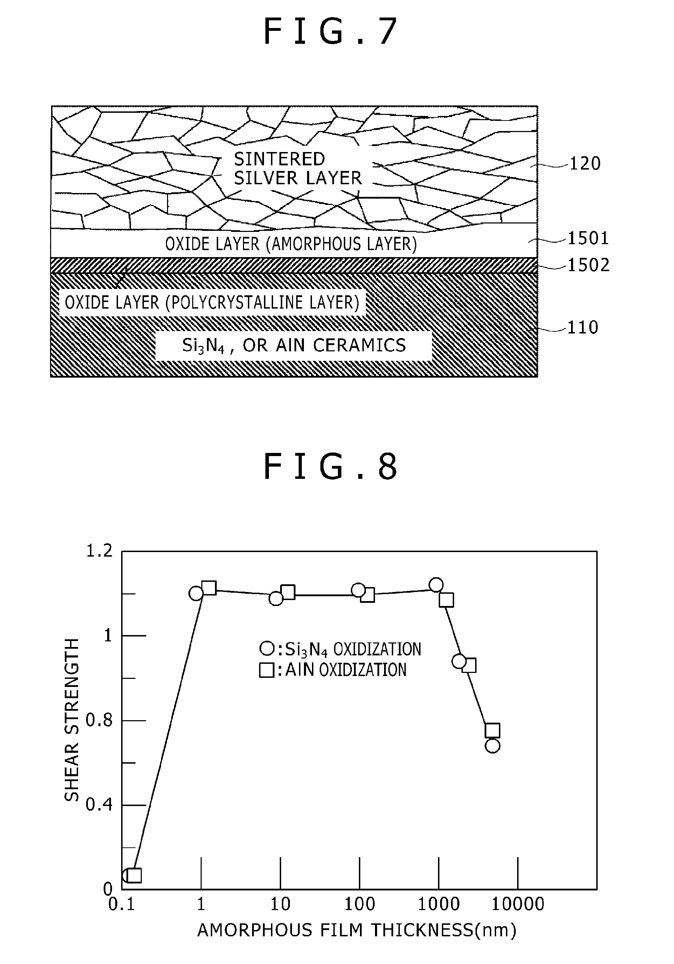

FIG. 6 and FIG. 7 are diagrams showing states of cross sections of the joining portion with the surface oxidized Si₃N₄. The circuit board of this Example is in the state of the joining to the sintered silver layer 120 formed on the surface of the nitride ceramics 110 through an oxide 150 as shown in FIG. 6. In particular, with regard to the structure of the circuit board, as shown in FIG. 7, the thickness of the oxide layer on the surface of the nitride ceramics is 1 nm to 10 µm, and a region having a thickness of 0.1 nm to 100 nm from the interface of the joining portion to the sintered silver layer is in an amorphous state. It is noted that although when the oxide is formed on the entire surface of the ceramics substrate 110 as with Example 1, the oxide layer in the joining portion between the ceramics substrate and the sintered body, as shown in FIG. 7, is composed of an amorphous layer 1501 and a polycrystalline layer 1502, the oxide layer on the surface of the ceramics substrate in the region which is not joined by the sintered body is composed of only the polycrystalline layer 1502. That is to say, it is guessed that although the oxide layer on the surface of the ceramics substrate before the joining is composed of the polycrystalline layer, the polycrystalline layer of the joining interface turns into the amorphous layer in the phase of the joining, whereby the strong joining is attained in the interface between the amorphous layer and the sintered body. In addition, even in the case where the surface oxidized AlN was used, the same joining state was obtained as that in the case where the surface oxidized Si₃N₄ described above was used. It is noted that each of the polycrystalline layer and the amorphous layer of the oxide becomes the oxide layer of an element composing the ceramics substrate. For example, when the surface oxidized Si₃N₄ is used, each of the polycrystalline layer and the amorphous layer of the oxide is made of SiO₂, and when the surface oxidized AlN is used, each of the polycrystalline layer and the amorphous layer of the oxide is made of Al₂O₃.

FIG. 8 shows the joining strength with respect to the thickness of the amorphous layer. An axis of ordinate represents the strength in shear which is normalized by the value of the strength in shear for the Ag electrode similarly to the case of FIG. 4. As a result, it was found out that when the thickness of the amorphous film is equal to or larger than 0.1 nm, the high strength is obtained, and when the thickness of the amorphous film exceeds 100 nm, the strength is reduced.

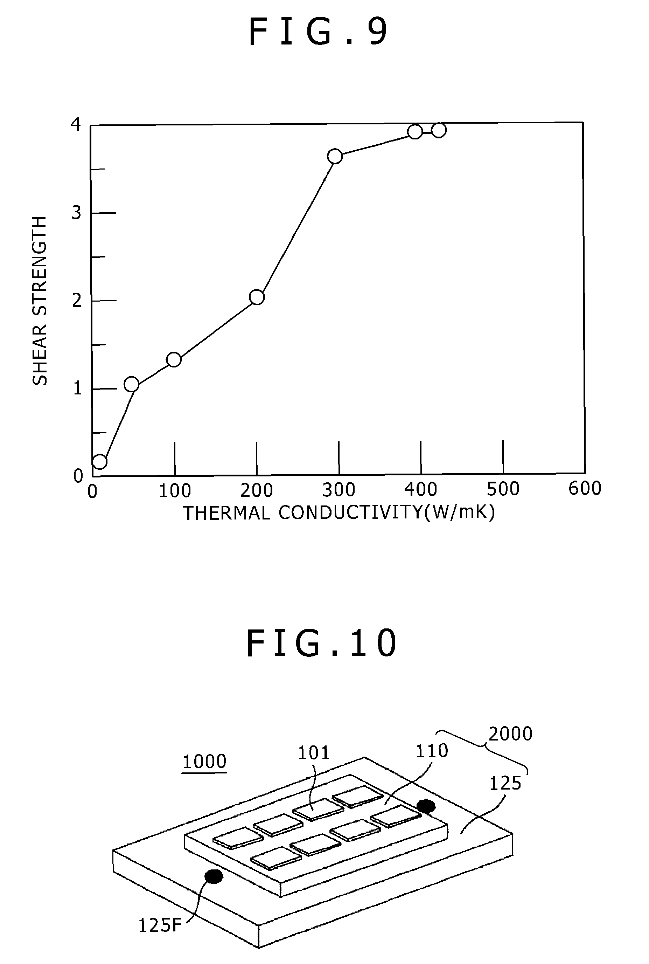

FIG. 9 shows a change in a strength in shear for a surface oxidized silicon nitride board with respect to thermal conductivity of a sintered silver joining layer. An axis of ordinate represents the strength in shear which is normalized by the value of the strength in shear for the Ag electrode similarly to the case of FIG. 4. As a result, it was found out that when the thermal conductivity is equal to or larger than 50 W/mK, the favorable joining strength is shown. It was also found out that when the thermal conductivity exceeds 400 W/mK, the same strength is shown.

It is noted that each of the back surface metallic board 125' and the wiring board 130 may be made of a copper system material, aluminum or an aluminum system material in addition to copper.

Although in Example 1, the silver oxide particles were used as the metallic particle precursor of the joining material, it is confirmed that other than those, a copper oxide can be selected. In addition thereto, it is confirmed that silver acetate, silver formate, copper acetate, and copper formate can also be selected, and the same effect is obtained.

It was found out from the above results that the joining is carried out in the atmosphere by using the joining material containing therein the oxide metallic particles and the reducing agent, whereby the joining to the surface-oxidized ceramics is possible.

### (Example 2)

FIG. 10 is a schematic view explaining a main portion of the semiconductor device. This figure shows a state in which the semiconductor base substance 101 is mounted to an insulating board 2000 in which a silicon nitride board (30 × 50 × 0.3 mm; surface oxidization) as the ceramics substrate 110, and a copper board 125 as the supporting member are integrated with each other by the soldering. A Ni plating layer (thickness: 6 µm, not shown) is provided in an exposed portion of the copper board 125. The supporting member 125 has a size of 42.4 mm × 85 mm × 3 mm, and a mounting hole (diameter: 5.6 mm) 125F is provided in a peripheral portion of the supporting member 125. The supporting member 125 and the ceramics substrate 110 are integrated with each other by the joining layer 120 (thickness: 50 µm, not shown) made of the same silver oxide system material as that in the case of Example 1, and eight MOS FET element base substances (7 × 7 × 0.28 mm) 101 as the semiconductor base substances 101 are mounted on the circuit board 130 (thickness: 0.4 mm, not shown) made of the copper alloy and provided on the silicon nitride insulating board 110.

The element base substance 101 and the circuit wiring board 130 are joined to each other by the Sn-3Ag-0.5 Cu solder material 113 (thickness: 100 µm, not shown). The semiconductor device 1000 of Example 2 having such a main portion structure has a maximum power consumption of 400 W, and the insulating board 2000 having the cross section structure shown in FIG. 2 is applied thereto.

### Description of Reference Symbols

- 20: Resin case
- 21: Resin cover
- 22: Silicon gel resin, epoxy resin
- 25: Depression
- 30: Main terminal, terminal
- 101: Semiconductor base substrate, MOS FET element base substrate, IGBT element base substrate
- 110: Ceramics substrate, silicon nitride board, aluminum nitride board
- 113, 124: Joining layer
- 120: Joining layer
- 125: Circuit board
- 125': Supporting member
- 125F: Mounting hole
- 130: Circuit wiring board
- 1000: Semiconductor device

## Claims

1. A circuit board, comprising:
a ceramics substrate containing therein a nitride;
a circuit wiring board joined to one surface of said ceramics substrate through a joining layer; and
a metallic supporting member joined to the other surface of said ceramics substrate through a joining layer,
wherein said joining layer is a sintered body containing therein silver or copper,
wherein an oxide layer is formed in a joining interface between said ceramics substrate and said sintered body, and
wherein said oxide layer is composed of a polycrystalline layer on a side of said ceramics substrate, and is composed of an amorphous layer on a side of said sintered body.

2. The circuit board according to claim 1, wherein said oxide layer has a thickness of 1 nm to 10 µm.

3. The circuit board according to claim 1 or 2, wherein said amorphous layer has a thickness of 0.1 nm to 100 nm.

4. The circuit board according to any one of claims 1 to 3, wherein said ceramics substrate is a silicon nitride or an aluminum nitride.

5. The circuit board according to claim 4, wherein said oxide layer is an oxide of either silicon or aluminum.

6. The circuit board according to any one of claims 1 to 5, wherein thermal conductivity of said sintered body is 50 W/mK to 430 W/mK.

7. A semiconductor device, comprising:
a ceramics substrate containing therein a nitride;
a circuit wiring board joined to one surface of said ceramics substrate through a joining layer;
a metallic supporting member joined to the other surface of said ceramics substrate through a joining layer; and
a semiconductor element mounted on said circuit wiring board,
wherein said joining layer is a sintered body containing therein silver or copper,
wherein an oxide layer is formed in a joining interface between said ceramics substrate and said sintered body, and
wherein said oxide layer is composed of a polycrystalline layer on a side of said ceramics substrate, and is composed of an amorphous layer on a side of said sintered body.

8. The semiconductor device according to claim 7, wherein said oxide layer has a thickness of 1 nm to 10 µm.

9. The semiconductor device according to claim 7 or 8, wherein said amorphous layer has a thickness of 0.1 nm to 100 nm.

10. The semiconductor device according to any one of claim 7 to 9, wherein said ceramics substrate is a silicon nitride or an aluminum nitride.

11. The semiconductor device according to claim 10, wherein said oxide layer is an oxide of either silicon or aluminum.

12. The semiconductor device according to any one of claim 7 to 11, wherein thermal conductivity of said sintered body is 50 W/mK to 430 W/mK.
